# EUROPÄISCHE PATENTSCHRIFT

(11) **EP 0 929 911 B1**
(45) Veröffentlichungstag und Bekanntmachung des Hinweises auf die Patenterteilung: **14.07.2004**
(21) Anmeldenummer: 98933425.5
(22) Anmeldetag: 24.04.1998
(51) Int. Cl.: H01L 41/04

(54) **VERFAHREN UND VORRICHTUNG ZUM LADEN UND ENTLADEN EINES PIEZOELEKTRISCHEN ELEMENTS**
METHOD AND DEVICE FOR CHARGING AND DISCHARGING A PIEZOELECTRIC ELEMENT
PROCEDE ET DISPOSITIF POUR CHARGER ET DECHARGER UN ELEMENT PIEZOELECTRIQUE

(30) Priorität: 02.08.1997 DE 19733560
(43) Veröffentlichungstag der Anmeldung: 21.07.1999
(73) Patentinhaber: ROBERT BOSCH GMBH, 70442 Stuttgart (DE)
(72) Erfinder: REINEKE, Jörg, D-70469 Stuttgart (DE); HOCK, Alexander, D-70435 Stuttgart (DE)
(86) Internationale Anmeldenummer: PCT/DE1998/001158
(87) Internationale Veröffentlichungsnummer: WO 1999/007026

(56) Entgegenhaltungen:
- EP-A- 0 871 230
- DE-A- 4 435 832
- PATENT ABSTRACTS OF JAPAN vol. 016, no. 282 (M-1269), 23. Juni 1992 & JP 04 071859 A (BROTHER IND LTD), 6. März 1992

## Beschreibung

Die vorliegende Erfindung betrifft ein Verfahren gemäß dem Oberbegriff des Patentanspruchs 1 und eine Vorrichtung gemäß dem Oberbegriff des Patentanspruchs 10, d.h. ein Verfahren und eine Vorrichtung zum Laden und Entladen eines piezoelektrischen Elements, wobei der das piezoelektrische Element ladende Ladestrom bzw. der das piezoelektrische Element entladende Entladestrom über ein induktive Eigenschaften aufweisendes Bauelement geführt wird.

Bei den vorliegend näher betrachteten piezoelektrischen Elementen handelt es sich insbesondere, aber nicht ausschließlich um als Aktoren bzw. Stellglieder verwendete piezoelektrische Elemente. Piezoelektrische Elemente lassen sich für derartige Zwecke einsetzen, weil sie bekanntermaßen die Eigenschaft aufweisen, sich in Abhängigkeit von einer daran angelegten Spannung zusammenzuziehen oder auszudehnen.

Die praktische Realisierung von Stellgliedern durch piezoelektrische Elemente erweist sich insbesondere dann von Vorteil, wenn das betreffende Stellglied schnelle und/oder häufige Bewegungen auszuführen hat.

Der Einsatz von piezoelektrischen Elementen als Stellglied erweist sich unter anderem bei Kraftstoff-Einspritzdüsen für Brennkraftmaschinen als vorteilhaft. Zur Einsetzbarkeit von piezoelektrischen Elementen in Kraftstoff-Einspritzdüsen wird beispielsweise auf die EP 0 371 469 B1 und die EP 0 379 182 B1 verwiesen.

Die nicht vorveröffentlichte D3 zeigt ein Verfahren und eine Vorrichtung zum Laden und Entladen eines piezoelektrischen Elements. Der Lade- bzw. der Entladestrom des piezoelektrischen Elements wird dabei über ein induktive Eigenschaften aufweisendes Bauelement geführt. Dabei ist vorgesehen, dass ein im Ladestromkreis bzw. Entladestromkreis vorgesehener Schalter während des Ladens bzw. Entladens wiederholt derart betätigt wird, bis das piezoelektrische Element eine vorgegebene Spannung erreicht hat.

Die Vorrichtung zum Laden und Entladen eines piezoelektrischen Elements gemäß dem Patent Abstracts of Japan vol. 016, no. 282 (M-1269) wird zur Steuerung eines Tintenstrahldruckers eingesetzt. Dabei wird das piezoelektrische Element für eine vorgegebene Zeit geladen und nach einer vorgegebenen Zeit, die für den Druckvorgang notwendig ist, entladen.

Die DE 44 35 832 beschreibt eine Schaltungsanordnung zur schnellen und verlustfreien Ladung und Entladung kapazitiver Lasten. Hier wird durch mehrmaliges Betätigen eines Lade- bzw. Entladeschalters ein piezoelektrisches Element geladen bzw. entladen. Die Anzahl der Ladevorgänge hängt dabei von der gewünschten Spannung, die am piezoelektrischen Element anliegen soll, ab. Die Anzahl der Ladevorgänge wird abhängig von der gewünschten einzustellenden Spannung vorgegeben.

Piezoelektrische Elemente sind kapazitive Verbraucher, welche sich, wie vorstehend bereits angedeutet wurde, entsprechend dem jeweiligen Ladungszustand bzw. der sich daran einstellenden oder angelegten Spannung zusammenziehen und ausdehnen.

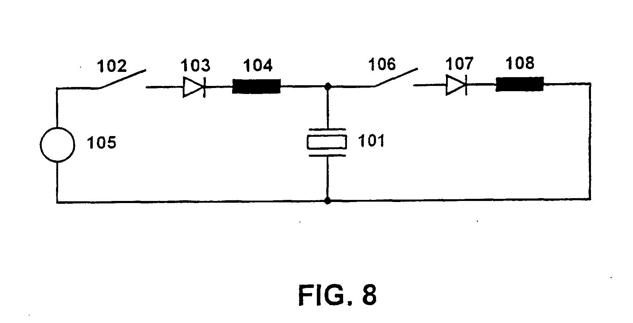

Das Laden und Entladen eines piezoelektrischen Elements kann unter anderem über ein induktive Eigenschaften aufweisendes Bauelement wie beispielsweise eine Spule erfolgen, wobei diese Spule in erster Linie dazu dient, den beim Laden auftretenden Ladestrom und den beim Entladen auftretenden Entladestrom zu begrenzen. Eine solche Anordnung ist in Figur 8 veranschaulicht.

Das zu ladende bzw. zu entladende piezoelektrische Element ist in der Figur 8 mit dem Bezugszeichen 101 bezeichnet. Es ist Bestandteil eines über einen Ladeschalter 102 schließbaren Ladestromkreises und eines über einen Entladeschalter 106 schließbaren Entladestromkreises, wobei der Ladestomkreis aus einer Serienschaltung des Ladeschalters 102, einer Diode 103, einer Ladespule 104, des piezoelektrischen Elements 101, und einer Spannungsquelle 105 besteht, und wobei der Entladestromkreis aus einer Serienschaltung des Entladeschalters 106, einer Diode 107, einer Entladespule 108 und des piezoelektrischen Elements 101 besteht.

Die Diode 103 des Ladestromkreises verhindert, daß im Ladestromkreis ein das piezoelektrische Element entladender Strom fließen kann. Die Diode 103 und der Ladeschalter 102 sind gemeinsam als ein Halbleiterschalter realisierbar.

Die Diode 107 des Entladestromkreises verhindert, daß im Entladestromkreis ein das piezoelektrische Element ladender Strom fließen kann. Die Diode 107 und der Ladeschalter 106 sind wie die Diode 103 und der Ladeschalter 102 gemeinsam als ein Halbleiterschalter realisierbar.

Wird der normalerweise geöffnete Ladeschalter 102 geschlossen, so fließt im Ladestromkreis ein Ladestrom, durch welchen das piezoelektrische Element 101 geladen wird; die im piezoelektrischen Element 101 gespeicherte Ladung bzw. die sich an diesem dadurch einstellende Spannung und damit auch die aktuellen äußeren Abmessungen des piezoelektrischen Elements 101 werden nach dem Laden desselben im wesentlichen unverändert beibehalten.

Wird der normalerweise ebenfalls geöffnete Entladeschalter 106 geschlossen, so fließt im Entladestromkreis ein Entladestrom, durch welchen das piezoelektrische Element 101 entladen wird; der Ladezustand des piezoelektrischen Elements 101 bzw. die sich an diesem dadurch einstellende Spannung und damit auch die aktuellen äußeren Abmessungen des piezoelektrischen Elements 101 werden nach dem Entladen desselben im wesentlichen unverändert beibehalten.

Ein derartiges Laden und Entladen von piezoelektrischen Elementen ist vorteilhaft, weil es mangels nennenswerter ohmscher Widerstände im Ladestromkreis und im Entladestromkreis verlustleistungsarm und unter nur relativ geringer Wärmeentwicklung erfolgen kann.

Andererseits sind aber das Ausmaß und der zeitliche Verlauf des Ladens und des Entladens häufig nicht ideal. Störend sind vor allem zeitlich variierende Lade- und Entladegeschwindigkeiten, mehr oder weniger stark ausgeprägte Einschwingvorgänge und ein nur teilweises oder zu starkes Laden und/oder Entladen des piezoelektrischen Elements, wodurch beim Entladen sogar ein Aufladen mit entgegengesetzter Polarität erfolgen kann.

Es dürfte einleuchten, daß dies nicht nur eine nicht unerhebliche Belastung für das zu ladende bzw. zu entladende piezoelektrische Element darstellt, sondern auch dessen bestimmungsgemäßen Gebrauch beeinträchtigen kann.

Der vorliegenden Erfindung liegt daher die Aufgabe zugrunde, das Verfahren gemäß dem Oberbegriff des Patentanspruchs 1 bzw. die Vorrichtung gemäß dem Oberbegriff des Patentanspruchs 9 derart weiterzubilden, daß das Laden und das Entladen von piezoelektrischen Elementen schonend für diese und einfach an die individuellen oder wechselnde Verhältnisse anpaßbar durchgeführt werden können.

Diese Aufgabe wird erfindungsgemäß durch die im kennzeichnenden Teil des Patentanspruchs 1 (Verfahren) und durch die im kennzeichnenden Teil des Patentanspruchs 9 (Vorrichtung) beanspruchten Merkmale gelöst.

Durch das wiederholte Öffnen und Schließen der jeweiligen Schalter wird ein getaktetes Laden bzw. Entladen durchgeführt. Dadurch ändern sich die Funktion und Wirkungsweise des die induktiven Eigenschaften aufweisenden Bauelements.

Bisher wirkte es als das induktive Element eines im Zusammenwirken mit dem piezoelektrische Element gebildeten LC-Reihenschwingkreises, wobei die Induktivität des induktiven Elements und die Kapazität des piezoelektrischen Elements allein den Verlauf und den Umfang des Ladens und des Entladen bestimmten (geladen und entladen werden konnte jeweils nur mit der ersten Stromhalbwelle der ersten Schwingkreisschwingung, denn ein Weiterschwingen des Schwingkreises wird durch die im Ladestromkreis und Entladestromkreis enthaltenen Dioden unterbunden).

Jetzt (bei der getakteten Ansteuerung) wird das die induktiven Eigenschaften aufweisende Element als ein EnergieZwischenspeicher verwendet, der abwechselnd von der Stromversorgungsquelle (beim Laden) bzw. vom piezoelektrischen Element (beim Entladen) zugeführte elektrische Energie (in Form von magnetischer Energie) speichert und - nach einer entsprechenden Schalterbetätigung - die gespeicherte Energie in Form von elektrischer Energie an das piezoelektrische Element (beim Laden) bzw. einen anderen Energiespeicher oder einen elektrischen Verbraucher (beim Entladen) abgibt, wobei die Zeitpunkte und die Dauer (und damit auch der Umfang) der Energiespeicherung und der Energieabgabe durch die Schalterbetätigung(en) bestimmt werden.

Dadurch kann das piezoelektrische Element in beliebig vielen, beliebig großen und in beliebigen zeitlichen Abständen aufeinanderfolgenden Stufen wunschgemäß weit geladen und entladen werden.

Als Folge dessen können sowohl das Ausmaß als auch der zeitliche Verlauf des Ladens und/oder des Entladens wunschgemäß beeinflußt werden, und zwar weitgehend unabhängig von den technischen Daten des die induktiven Eigenschaften aufweisenden Bauelements und des piezoelektrischen Elements.

Nutzt man die gegebenen Möglichkeiten dahingehend aus, daß man die Schalter derart wiederholt öffnet und schließt, daß das piezoelektrische Element durch einen vorgegebenen mittleren Lade- bzw. Entladestrom auf eine vorgegebene Spannung gebracht wird, so können das Laden und das Entladen von piezoelektrischen Elementen schonend für diese und einfach an die individuellen und wechselnden Verhältnisse anpaßbar durchgeführt werden.

Die zumindest teilweise Entkopplung des Ausmaßes und des zeitlichen Verlaufs des Ladens und/oder des Entladens von den technischen Daten des die induktiven Eigenschaften aufweisenden Elements und des piezoelektrischen Elements ermöglicht es darüber hinaus, nur ein einziges induktive Eigenschaften aufweisendes Element vorzusehen und dieses sowohl zum Laden als auch zum Entladen des piezoelektrischen Elements zu verwenden; beim eingangs beschriebenen herkömmlichen Verfahren zum Laden und Entladen eines piezoelektrischen Elements ist eine Zusammenfassung der Ladespule und der Entladespule nicht ohne weiteres möglich, weil diese vorzugsweise unterschiedliche Induktivitäten aufweisen.

Das die induktiven Eigenschaften aufweisende Element kann bei Bedarf sehr klein ausgebildet werden; die geringe Energiespeicherkapazität bzw. das schnelle Erreichen der Sättigung kann durch Vorsehen einer erhöhten Anzahl von Lade- und/oder Entladetakten ausgeglichen werden.

Dadurch läßt sich die Anordnung zum Laden und Entladen von piezoelektrischen Elementen trotz deren verbesserter Funktion erheblich kleiner aufbauen als es bislang möglich war.

Weitere vorteilhafte Weiterbildungen der Erfindung sind Gegenstand der Unteransprüche.

Die Erfindung wird nachfolgend anhand von Ausführungsbeispielen unter Bezugnahme auf die Zeichnung näher erläutert. Es zeigen
- Figur 1: eine gegenüber herkömmlichen Anordnungen vereinfacht aufgebaute Anordnung zum Laden und Entladen eines piezoelektrischen Elements,
- Figur 2: eine Darstellung zur Erläuterung der sich während einer ersten Ladephase (Ladeschalter 3 geschlossen) in der Anordnung nach Figur 1 einstellenden Verhältnisse,
- Figur 3: eine Darstellung zur Erläuterung der sich während einer zweiten Ladephase (Ladeschalter 3 wieder geöffnet) in der Anordnung nach Figur 1 einstellenden Verhältnisse,
- Figur 4: eine Darstellung zur Erläuterung der sich während einer ersten Entladephase (Entladeschalter 5 geschlossen) in der Anordnung nach Figur 1 einstellenden Verhältnisse,
- Figur 5: eine Darstellung zur Erläuterung der sich während einer zweiten Entladephase (Entladeschalter 5 wieder geöffnet) in der Anordnung nach Figur 1 einstellenden Verhältnisse,
- Figur 6: den zeitlichen Verlauf von sich bei der erfindungsgemäßen Ansteuerung der Anordnung gemäß Figur 1 einstellenden Spannungs- und Stromverläufen,
- Figur 7: eine schematische Darstellung des zeitlichen Verlaufs der sich an einem piezoelektrischen Element während des Ladens einstellenden Spannung, und
- Figur 8: eine herkömmliche Anordnung zum Laden und Entladen eines piezoelektrischen Elements.

Die piezoelektrischen Elemente, deren Laden und Entladen im folgenden näher beschrieben wird, sind beispielsweise als Stellglieder in Kraftstoff-Einspritzdüsen (insbesondere in sogenannten Common Rail Injektoren) von Brennkraftmaschinen einsetzbar. Auf einen derartigen Einsatz der piezoelektrischen Elemente besteht jedoch keinerlei Einschränkung; die piezoelektrischen Elemente können grundsätzlich in beliebigen Vorrichtungen für beliebige Zwecke eingesetzt werden.

Es wird davon ausgegangen, daß sich die piezoelektrischen Elemente im Ansprechen auf das Laden ausdehnen und im Ansprechen auf das Entladen zusammenziehen. Die Erfindung ist selbstverständlich jedoch auch dann anwendbar, wenn dies gerade umgekehrt ist.

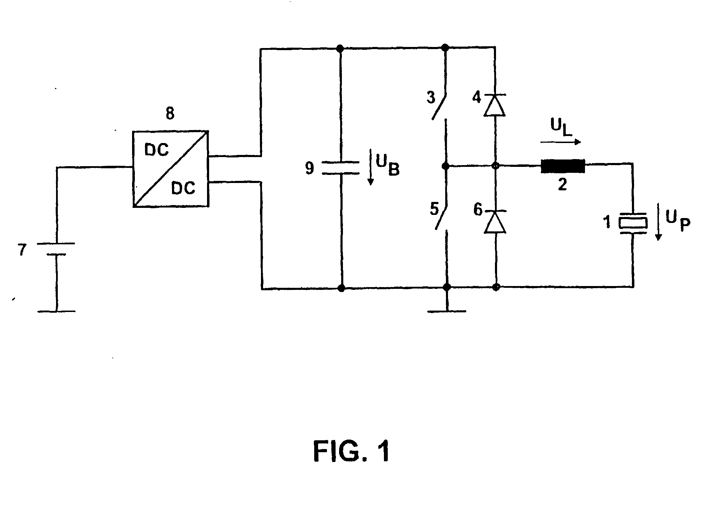

Es wird nun unter Bezugnahme auf Figur 1 eine gegenüber herkömmlichen Anordnungen vereinfachte Anordnung zum Laden und Entladen eines piezoelektrischen Elements beschrieben, wobei die Vereinfachung in erster Linie durch den Einsatz des erfindungsgemäßen Verfahrens bzw. der erfindungsgemäßen Vorrichtung ermöglicht wird.

Das piezoelektrische Element, das es im betrachteten Beispiel zu laden gilt, ist in der Figur 1 mit dem Bezugszeichen 1 bezeichnet.

Wie aus der Figur 1 ersichtlich ist, liegt der eine der Anschlüsse des piezoelektrischen Elements 1 dauerhaft auf Masse (ist mit einem ersten Pol einer Spannungsquelle verbunden), wohingegegen der andere der Anschlüsse des piezoelektrischen Elements über eine (zugleich als Ladespule und Entladespule wirkende) Spule 2 und eine Parallelschaltung aus einem Ladeschalter 3 und einer Diode 4 mit dem zweiten Pol der Spannungsquelle und über die Spule 2 und eine Parallelschaltung aus einem Entladeschalter 5 und einer Diode 6 mit dem ersten Pol der Spannungsquelle verbunden ist.

Die Spannungsquelle besteht aus einer Batterie 7 (beispielsweise einer KFZ-Batterie), einem dieser nachgeschalteten Gleichspannungswandler 8, und einem diesem nachgeschalteten, als Pufferkondensator dienenden Kondensator 9. Durch diese Anordnung wird die Batteriespannung (beispielsweise 12 V) in eine im wesentlichen beliebige andere Gleichspannung umgesetzt und als Versorgungsspannung bereitgestellt.

Das Laden und das Entladen des piezoelektrischen Elements 1 erfolgen im betrachteten Beispiel getaktet. D.h., der Ladeschalter 3 und der Entladeschalter 5 werden während des Lade- bzw. Entladevorganges wiederholt geschlossen und geöffnet.

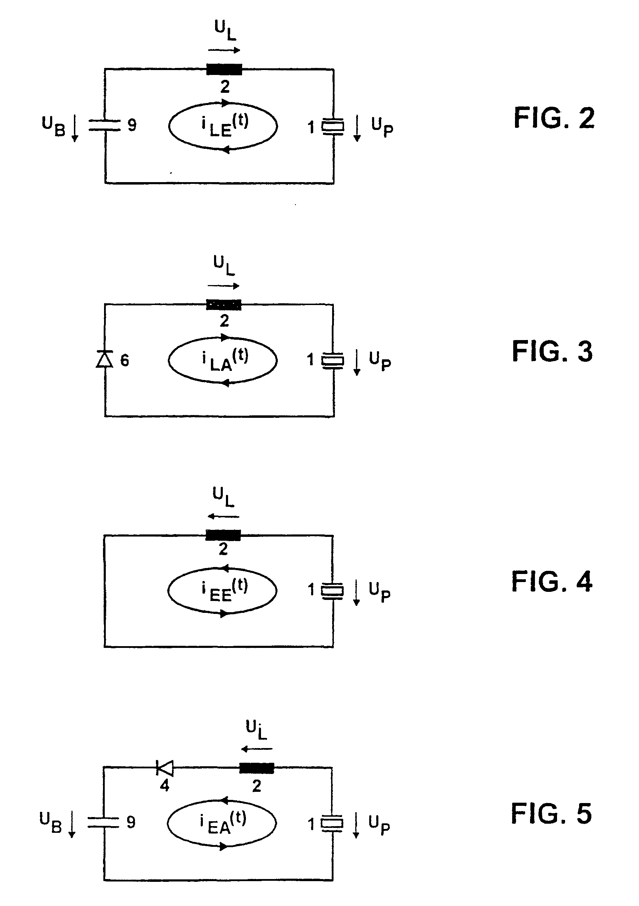

Die sich dabei einstellenden Verhältnisse werden nachfolgend unter Bezugnahme auf die Figuren 2 bis 5 erläutert, von denen die Figuren 2 und 3 das Laden des piezoelektrischen Elements 1, und die Figuren 4 und 5 das Entladen des piezoelektrischen Elements 1 veranschaulichen.

Der Ladeschalter 3 und der Entladeschalter 5 sind, wenn und solange kein Laden oder Entladen des piezoelektrischen Elements 1 erfolgt, geöffnet. In diesem Zustand befindet sich die in der Figur 1 gezeigte Schaltung im stationären Zustand. D.h., das piezoelektrische Element 1 behält seinen Ladungszustand im wesentlichen unverändert bei, und es fließen keine Ströme.

Mit dem Beginn des Ladens des piezoelektrischen Elements 1 wird der Ladeschalter 3 wiederholt geschlossen und geöffnet; der Entladeschalter 5 bleibt hierbei geöffnet.

Beim Schließen des Ladeschalters 3 stellen sich die in der Figur 2 gezeigten Verhältnisse ein. D.h., es wird ein aus einer Reihenschaltung aus dem piezoelektrischen Element 1, dem Kondensator 9 und der Spule 2 bestehender geschlossener Stromkreis gebildet, in welchem ein wie in der Figur 2 durch Pfeile angedeuteter Strom i_{LE}(t) fließt. Dieser Stromfluß bewirkt, daß in der Spule 2 Energie gespeichert wird. Der Energiefluß in die Spule 2 wird dabei durch die positive Potentialdifferenz zwischen dem Kondensator 9 und dem piezoelektrischen Element 1 bewirkt.

Beim kurz (beispielsweise einige µs) nach dem Schließen des Ladeschalters 3 erfolgenden Öffnen desselben stellen sich die in der Figur 3 gezeigten Verhältnisse ein. D.h., es wird ein aus einer Reihenschaltung aus dem piezoelektrischen Element 1, der Diode 6 und der Spule 2 bestehender geschlossener Stromkreis gebildet, in welchem ein wie in der Figur 3 durch Pfeile angedeuteter Strom i_{LA}(t) fließt. Dieser Stromfluß bewirkt, daß in der Spule 2 gespeicherte Energie vollständig in das piezoelektrische Element 1 fließt. Entsprechend der Energiezufuhr zum piezoelektrischen Element erhöhen sich die an diesem einstellende Spannung und dessen äußere Abmessungen. Nach erfolgtem Energietransport von der Spule 2 zum piezoelektrischen Element 1 ist wieder der vorstehend bereits erwähnte stationäre Zustand der Schaltung nach Figur 1 erreicht.

Dann oder auch schon vorher oder auch erst später (je nach dem gewünschten zeitlichen Verlauf des Ladevorgangs) wird der Ladeschalter 3 erneut geschlossen und wieder geöffnet, wobei sich die vorstehend beschriebenen Vorgänge wiederholen. Durch das erneute Schließen und Öffnen des Ladeschalters 3 nimmt die im piezoelektrischen Element 1 gespeicherte Energie zu (die im piezoelektrischen Element bereits gespeicherte Energie und die neu zugeführte Energie summieren sich), und dementsprechend nehmen die sich am piezoelektrischen Element einstellende Spannung und dessen äußere Abmessungen zu.

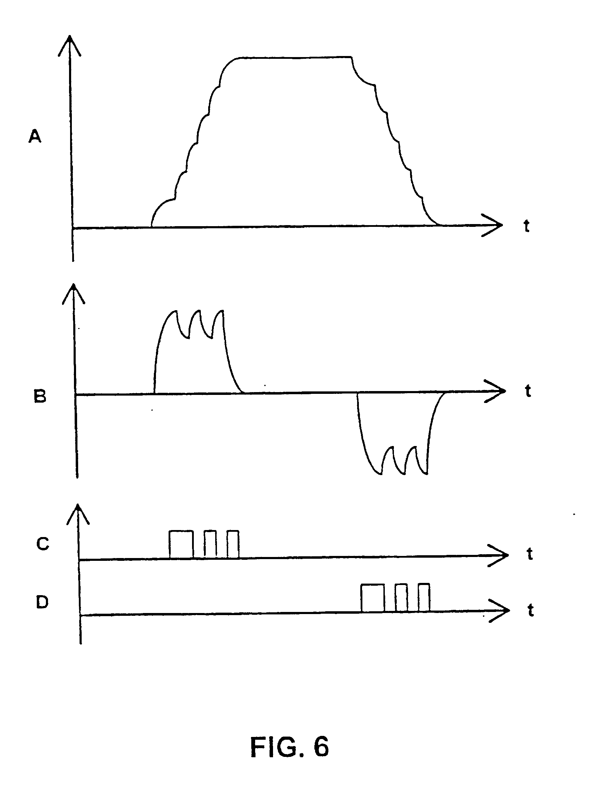

Wiederholt man das beschriebene Schließen und Öffnen des Ladeschalters 3 eine Vielzahl von Malen, so steigen die sich am piezoelektrischen Element einstellende Spannung und die Ausdehnung des piezoelektrischen Elements stufenweise an (siehe hierzu die Kurve A der später noch genauer erläuterten Figur 6).

Wurde der Ladeschalter 3 eine vorbestimmte Anzahl von Malen geschlossen und geöffnet und/oder hat das piezoelektrische Element 1 den gewünschten Ladezustand erreicht, so wird das Laden des piezoelektrischen Elements durch Offenlassen des Ladeschalters 3 beendet.

Soll das piezoelektrische Element 1 wieder entladen werden, so wird dies durch ein wiederholtes Schließen und Öffnen des Entladeschalters 5 bewerkstelligt; der Ladeschalter 3 bleibt hierbei geöffnet.

Beim Schließen des Entladeschalters 5 stellen sich die in der Figur 4 gezeigten Verhältnisse ein. D.h., es wird ein aus einer Reihenschaltung aus dem piezoelektrischen Element 1 und der Spule 2 bestehender geschlossener Stromkreis gebildet, in welchem ein wie in der Figur durch Pfeile angedeuteter Strom i_{EE} (t) fließt. Dieser Stromfluß bewirkt, daß die im piezoelektrischen Element gespeicherte Energie (ein Teil derselben) in die Spule 2 transportiert wird. Entsprechend dem Energietransfer vom piezoelektrischen Element 1 zur Spule 2 nehmen die sich am piezoelektrischen Element einstellende Spannung und dessen äußere Abmessungen ab.

Beim kurz (beispielsweise einige µs) nach dem Schließen des Entladeschalters 5 erfolgenden Öffnen desselben stellen sich die in der Figur 5 gezeigten Verhältnisse ein. D.h., es wird ein aus einer Reihenschaltung aus dem piezoelektrischen Element 1, dem Kondensator 9, der Diode 4 und der Spule 2 bestehender geschlossener Stromkreis gebildet, in welchem ein wie in der Figur durch Pfeile angedeuteter Strom i_{EA} (t) fließt. Dieser Stromfluß bewirkt, daß in der Spule 2 gespeicherte Energie vollständig in den Kondensator 9 zurückgespeist wird. Nach erfolgtem Energietransport von der Spule 2 zum Kondensator 9 ist wieder der vorstehend bereits erwähnte stationäre Zustand der Schaltung nach Figur 1 erreicht.

Dann oder auch schon vorher oder erst später (je nach dem gewünschten zeitlichen Verlauf des Entladevorgangs wird der Entladeschalter 5 erneut geschlossen und wieder geöffnet, wobei sich die vorstehend beschriebenen Vorgänge wiederholen. Durch das erneute Schließen und Öffnen des Entladeschalters 5 nimmt die im piezoelektrischen Element 1 gespeicherte Energie weiter ab, und dementsprechend nehmen die sich am piezoelektrischen Element einstellende Spannung und dessen äußere Abmessungen ebenfalls ab.

Wiederholt man das beschriebene Schließen und Öffnen des Entladeschalters 5 eine Vielzahl von Malen, so nehmen die sich am piezoelektrischen Element einstellende Spannung und die Ausdehnung des piezoelektrischen Elements stufenweise ab (siehe hierzu die Kurve A in der Figur 6).

Wurde der Entladeschalter 5 eine vorbestimmte Anzahl von Malen geschlossen und geöffnet und/oder hat das piezoelektrische Element den gewünschten Entladezustand erreicht, so wird das Entladen des piezoelektrischen Elements durch Offenlassen des Entladeschalters 5 beendet.

Das Ausmaß und der Verlauf des Ladens und des Entladens sind durch die Häufigkeit und die Dauer des Öffnens und Schließens des Ladeschalters 3 und des Entladeschalters 5 bestimmbar. Dies gilt nicht nur für die in der Figur 1 gezeigte Anordnung, sondern für alle Anordnungen, durch welche ein vergleichbares Laden und/oder Entladen von piezoelektrischen Elementen durchführbar ist; die besagten Anordnungen müssen dabei im wesentlichen "nur" für ein getaktetes Laden und Entladen eines oder auch mehrerer piezoelektrischer Elemente geeignet sein.

Die Betätigung des Ladeschalters 3 und des Entladeschalters 5 erfolgt durch eine in der Figur 1 nicht gezeigte Steuer- oder Regeleinrichtung. Diese Steuer- oder Regeleinrichtung führt ein derartiges Öffnen und Schließen des Ladeschalters 3 und des Entladeschalters 5 durch, daß das zu ladende bzw. zu entladende piezoelektrische Element dadurch unter Einhaltung eines vorgegebenen mittleren (Lade- bzw. Entlade-)Stromflusses auf eine vorgegebene Spannung gebracht wird.

Hierzu werden der Ladeschalter 3 bzw. der Entladeschalter 5 zu bestimmten Zeitpunkten geöffnet und geschlossen, wobei sich die Zeiten, während welcher die jeweiligen Schalter geschlossen sind, und die Zeiten, während welcher die jeweiligen Schalter geöffnet sind, gleich oder unterschiedlich lang sein können und selbst innerhalb eines jeweiligen Lade- bzw. Entladevorganges beliebig verändert werden können.

Die Dauer und die Häufigkeit des Öffnens und Schließens des Ladeschalters 3 und des Entladeschalters 5 hängen vom Aufbau und den technischen Daten der das piezoelektrische Element ladenden bzw. entladenden Anordnung sowie dem angestrebten Ausmaß und dem angestrebten Verlauf des Ladens und Entladens ab, wobei das optimale Ausmaß und der optimale Verlauf des Ladens bzw. Entladens ihrerseits wiederum von den momentanen Betriebsbedingungen der Einrichtung abhängen, in welcher das piezoelektrische Element eingesetzt wird.

Wird das piezoelektrische Element wie vorliegend als Aktor in einer Kraftstoff-Einspritzdüse eines Common Rail Injectors einer Brennkraftmaschine eingesetzt, so variieren das erforderliche Ausmaß und der erforderliche Verlauf des Ladens und des Entladens insbesondere in Abhängigkeit von
1) der pro Einspritzvorgang einzuspritzenden Kraftstoffmenge,
2) der Motordrehzahl,
3) dem Druck im Rail, und
4) der Motortemperatur;
von diesen Parametern hängt es ab, innerhalb welcher Zeit das zu ladende bzw. zu entladende piezoelektrische Element wie weit geladen bzw. entladen werden sollte bzw. muß, also welcher Ladestrom bzw. Entladestrom fließen muß, um das piezoelektrische Element spätestens nach der zur Verfügung stehenden Zeit wunschgemäß weit geladen oder entladen zu haben.

Daß der so oder anders festgelegte Lade- bzw. Entladestrom tatsächlich auch fließt, kann durch eine Steuereinrichtung oder eine Regeleinrichtung erreicht werden, wobei der Stromfluß jedoch sowohl bei der Steuerung als auch bei der Regelung durch ein entsprechend häufiges und langes Öffnen und Schließen des Ladeschalters bzw. des Entladeschalters eingestellt wird.

Bei der Steuerung muß vorab eine Festlegung der Ein- und Ausschaltzeitpunkte und/oder der Dauer der jeweiligen Schaltzustände des Ladeschalters und des Entladeschalters erfolgen oder zumindest eine Rechenvorschrift zur Berechnung derselben ermittelt werden. Hierzu wird für die das piezoelektrische Element ladende und entladende Anordnung einschließlich des piezoelektrischen Elements, also beispielsweise für die in der Figur 1 gezeigte Anordnung ein Modell (Ersatzschaltbild) gebildet bzw. erstellt. Für die in diesem Modell interessierenden Größen, also insbesondere für den das piezoelektrische Element ladenden und entladenden Strom und die sich am piezoelektrischen Element als Folge dessen einstellende Spannung werden Gleichungen (Differentialgleichungen) aufgestellt, und aus diesen Gleichungen läßt sich schließlich berechnen, zu welchen Zeitpunkten der Ladeschalter und der Entladeschalter geöffnet und geschlossen werden müssen bzw. wie lange der Ladeschalter und der Entladeschalter jeweils geöffnet und geschlossen bleiben müssen, um das piezoelektrische Element durch den vorgegebenen Strom auf die vorgegebene Spannung zu bringen.

Die Schaltzeitpunkte für den Ladeschalter und den Entladeschalter können im voraus berechnet und in einem Speicher der Steuereinrichtung abgelegt werden. Die gespeicherten Daten können dann während des Betriebs des piezoelektrischen Elements aus dem Speicher ausgelesen und zur Schalterbetätigung verwendet werden.

Die Schaltzeitpunkte für den Ladeschalter und den Entladeschalter können aber auch vor jeder Einspritzung aktuell berechnet werden.

In beiden Fällen, d.h. sowohl bei der Vorab-Berechnung der Schaltzeitpunkte als auch bei der aktuellen Berechnung der Schaltzeitpunkte können diese für verschiedene Betriebszustände berechnet werden, in welche insbesondere die vorstehend bereits genannten Parameter eingehen, von welchen der anzustrebende Umfang und der anzustrebende Verlauf des Ladens und Entladens abhängen.

Im Ergebnis gelangt man sowohl bei der Vorab-Berechnung der Schaltzeitpunkte als auch bei der aktuellen Berechnung der Schaltzeitpunkte zu einem Laden und Entladen des piezoelektrischen Elements wie es in Figur 6 beispielhaft veranschaulicht ist.

In der Figur 6 repräsentiert
- die mit A bezeichnete Kurve den Verlauf der sich am piezoelektrischen Element einstellenden Spannung,
- die mit B bezeichnete Kurve den Ladestrom bzw. den Entladestrom, durch den das piezoelektrische Element geladen bzw. entladen wird,
- die mit C bezeichnete Kurve den Schaltzustand des Ladeschalters, und
- die mit D bezeichnete Kurve den Schaltzustand des Entladeschalters.

Aus dem wie gezeigt erfolgenden wiederholten Schließen und Öffnen des Ladeschalters (Kurve C) resultiert ein zwar schwankender, aber im Mittel gleichbleibend großer Ladestrom (Kurve B), durch den sich am piezoelektrischen Element eine im Mittel gleichmäßig auf einen vorgegebenen Endwert ansteigende Spannung (Kurve A) einstellt; aus dem wie gezeigt erfolgenden wiederholten Schließen und Öffnen des Entladeschalters (Kurve D) resultiert ein zwar schwankender, aber im Mittel gleichbleibend großer Entladestrom (Kurve B), durch den sich am piezoelektrischen Element eine im Mittel gleichmäßig auf einen vorgegebenen Endwert abfallende Spannung (Kurve A) einstellt.

Das Laden und Entladen eines piezoelektrischen Elements unter Steuerung durch eine Steuereinrichtung hat gegenüber dem Laden und Entladen unter Regelung durch eine Regeleinrichtung den Vorteil, daß keine Sensoren zur Verfolgung des Lade- bzw. Entladestroms und der sich am piezoelektrischen Element einstellenden Spannung erforderlich sind, und daß Störgrößen keinen Einfluß auf die Ansteuerung nehmen können.

Die "Datenspeicherlösung", bei welcher die Schalterbetätigungszeitpunkte (oder diese repräsentierende Größen) in einem Speicher gespeichert sind, ist insofern vorteilhaft, als die Steuereinrichtung nicht durch Rechenaufwand belastet wird und Fehlberechnungen vor dem Speichern korrigiert werden können.

Andererseits hat die "Rechenlösung", bei welcher die Schalterbetätigungszeitpunkte (oder diese repräsentierende Größen) jeweils aktuell berechnet werden, den Vorteil, daß der Speicherplatzbedarf in der Steuereinrichtung gering ist und die berechneten Daten mit vergleichsweise geringem Aufwand ganz exakt auf die jeweiligen Verhältnisse (Betriebszustände) zugeschnitten werden können.

Bei einer Betätigung des Ladeschalters und des Entladeschalters durch eine Regeleinrichtung werden zunächst der mittlere (Soll-)Strom, durch den das piezoelektrische Element geladen und entladen werden soll, und die (Soll-)Endspannung, auf die das piezoelektrische Element gebracht werden soll, festgelegt. Bei dieser Festlegung wird dem Umstand Rechnung getragen, daß das piezoelektrische Element innerhalb einer vorgegebenen Zeitspanne auf eine gewünschte Spannung aufgeladen werden soll bzw. muß.

Wird das piezoelektrische Element wie vorliegend als Aktor in einer Kraftstoff-Einspritzdüse eines Common Rail Injectors einer Brennkraftmaschine eingesetzt, so variieren die vorgegebene Zeit und die gewünschte Spannung insbesondere in Abhängigkeit von
1) der pro Einspritzvorgang einzuspritzenden Kraftstoffmenge,
2) der Motordrehzahl,
3) dem Druck im Rail, und
4) der Motortemperatur.

Bei einem durch die Regeleinrichtung erfolgenden geregelten Laden und Entladen des piezoelektrischen Elements müssen in der Anordnung zum Laden und Entladen des piezoelektrischen Elements, also beispielsweise in der Anordnung gemäß Figur 1 Sensoren zur Erfassung des Lade- bzw. Entladestroms und der sich am piezoelektrischen Element einstellenden Spannung vorgesehen werden.

Der Lade- und Entladestrom wird dann beispielsweise durch einen Zwei-Punkt-Regler innerhalb eines Bandes um den Soll-Strom Iₛₒₗₗ gehalten, wobei das Band durch einen oberhalb des Soll-Stroms gelegenen Maximal-Strom Iₘₐₓ und einen unterhalb des Soll-Stroms gelegenen Minimal-Strom Iₘᵢₙ definiert (begrenzt) wird.

Der durch den Stromsensor gemessene tatsächliche Ladestrom bzw. Entladestrom Iᵢₛₜ wird laufend mit dem Maximal-Strom Iₘₐₓ und dem Minimal-Strom Iₘᵢₙ verglichen. Wird Iᵢₛₜ kleiner als Iₘᵢₙ oder größer als Iₘₐₓ, entfernt sich Iᵢₛₜ also zu weit von Iₛₒₗₗ, so wird durch die Regeleinrichtung eine veränderte Betätigung des Ladeschalters bzw. Entladeschalters veranlaßt. Ein zu hoher Strom kann durch ein kürzeres und/oder weniger häufiges Schließen des Ladeschalters bzw. Entladeschalters reduziert werden, und ein zu niedriger Strom kann durch ein längeres und/oder häufigeres Schließen des Ladeschalters bzw. Entladeschalters erhöht werden. Auf diese Weise kann das piezoelektrische Element durch einen im Mittel etwa gleichbleibend hohen Strom geladen und entladen werden.

Zugleich wird laufend die am piezoelektrischen Element gemessene Spannung Uᵢₛₜ mit der Soll-Endspannung Uₛₒₗₗ verglichen. Der Ladevorgang bzw. der Entladevorgang wird beendet, sobald Uₛₒₗₗ von Uᵢₛₜ erreicht wird. Das piezoelektrische Element kann dadurch durch einen im Mittel etwa gleichbleibend hohen Strom auf eine vorbestimmte Spannung gebracht werden.

Der Vergleich von Iᵢₛₜ mit Iₘᵢₙ und Iₘₐₓ und der Vergleich von Uᵢₛₜ mit Uₛₒₗₗ wird in analogen oder digitalen Vergleichern durchgeführt. Die Referenzwerte der Vergleicher, d.h. Iₘᵢₙ, Iₘₐₓ und Uₛₒₗₗ sind variabel, vorzugsweise betriebspunktabhängig einstellbar; es können jedoch auch fest eingestellte (nicht veränderliche) Werte sein.

Die sich beim Laden und beim Entladen des piezoelektrischen Elements unter Regelung durch die Regeleinrichtung ergebenden Verhältnisse entsprechen den in der Figur 6 dargestellten und unter Bezugnahme darauf beschrieben Verhältnissen.

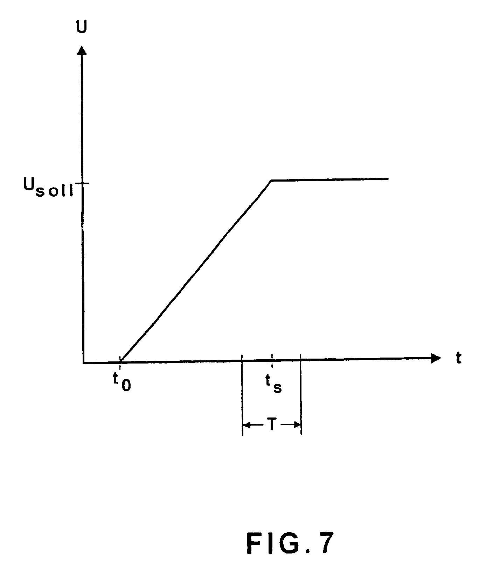

Verfolgt man den zeitlichen Verlauf der Ein- und/oder Ausgangssignale der Vergleicher, so kann daraus auf besonders einfache Art und Weise der zeitliche Verlauf und/oder Fortschritt des Ladens oder Entladens ermittelt bzw. überwacht werden. Weichen der ermittelte zeitliche Verlauf und/oder Fortschritt des Ladens und/oder Entladens von einem bekannten bestimmungsgemäßen Verlauf und/oder Fortschritt ab, so kann daraus auf bestimmte Beschädigungen und Alterungserscheinungen des oder der jeweils zu ladenden oder entladenden piezoelektrischen Elemente oder deren Zuleitungen geschlossen werden. Ein praktisches Beispiel wird nachfolgend unter Bezugnahme auf die Figur 7 beschrieben.

Die Figur 7 zeigt stark schematisiert den bestimmungsgemäßen Verlauf der sich an einem piezoelektrischen Element während des Ladens desselben einstellenden Spannung. Die Spannung steigt vom Beginn des Ladens an (Zeitpunkt t₀) im wesentlichen linear auf ihren Sollwert Uₛₒₗₗ an; auf das Erreichen des Sollwertes Uₛₒₗₗ hin, was bei dem betrachteten ordnungsgemäß funktionierenden System zum Zeitpunkt t₀ der Fall ist, wird der Ladevorgang beendet.

Die Zeit, während welcher das piezoelektrische Element geladen wird bzw. werden muß, um auf die Spannung Uₛₒₗₗ gebracht zu werden, kann aus den Ein- und/oder Ausgangssignalen der vorstehend bereits erwähnten Vergleicher ermittelt werden.

Im betrachteten Beispiel wird davon ausgegangen, daß es sich bei dem zu ladenden piezoelektrischen Element um eine Vielzahl von übereinandergestapelten Einzelelementen handelt.

Wird die Sollspannung ungefähr zum Zeitpunkt tₛ (innerhalb eines sich von tₛ - Δt bis tₛ + Δt erstreckenden Toleranzbereiches T) erreicht, so arbeiten das System und seine Komponenten ordnungsgemäß.

Wird die Sollspannung vor tₛ - Δt erreicht, liegt also eine gegenüber dem Normalfall verkürzte Ladezeit vor, so kann - sofern das Laden unter den üblichen Bedingungen, insbesondere mit dem üblichen Ladestrom durchgeführt wird - darauf geschlossen werden, daß das zu ladende piezoelektrische Element beschädigt oder gealtert ist. Die verkürzte Ladezeit deutet nämlich darauf hin, daß das zu ladende piezoelektrische Element eine gegenüber dem ungestörten Normalfall verringerte Kapazität aufweist, was seinerseits wiederum ein Anzeichen dafür ist, daß eines oder mehrere der übereinandergestapelten piezoelektrischen Einzelelemente ausgefallen sind oder jedenfalls nicht mehr ihre ursprünglichen Eigenschaften besitzen. Piezoelektrische Elemente weisen nämlich kapazitive Eigenschaften auf, wobei sich die Gesamtkapazität aus der Summe der Kapazitäten der piezoelektrischen Einzelelemente ergibt.

Verläuft die Verkürzung der Ladezeit sprungartig, so deutet dies auf eine Beschädigung einzelner oder mehrerer piezoelektrischer Einzelelemente hin. Stellt sich die Verkürzung der Ladezeit nur allmählich ein, so kann eine Beschädigung oder aber auch eine Alterung die Ursache sein.

Wird die Sollspannung nach tₛ + Δt erreicht, liegt also eine gegenüber dem Normalfall verlängerte Ladezeit vor, so kann - sofern das Laden unter den üblichen Bedingungen durchgeführt wird - darauf geschlossen werden, daß die Zuleitung zum piezoelektrischen Element beschädigt ist; in diesem Fall kann nämlich kein oder jedenfalls nicht der gewünschte Strom zum piezoelektrischen Element fließen.

Die selben Schlußfolgerungen lassen sich ziehen, wenn zusätzlich oder alternativ verkürzte oder verlängerte Entladezeiten detektiert werden.

Es erweist sich als günstig, wenn ungewöhnlich kurze oder lange Lade- und/oder Entladezeiten zum Anlaß genommen werden, vor einem möglichen Ausfall bzw. einer bereits eingetretenen Verschlechterung des das betreffende piezoelektrische Element enthaltenden Systems zu warnen.

Auf die beschriebene Art und Weise kann der Zustand des piezoelektrischen Elements allein durch eine Überwachung der Lade- und/oder Entladezeiten desselben überprüft werden. Erreicht die sich am piezoelektrischen Element einstellende Spannung bereits vor oder erst nach einer vorbestimmten Zeit nach einem bestimmten Ereignis oder Zeitpunkt die Sollspannung, so kann zweifelsfrei darauf geschlossen werden, daß das piezoelektrische Element oder dessen Zuleitung aufgrund von Defekten oder Alterungsprozessen nicht mehr ordnungsgemäß arbeitet, wobei die Ursache hierfür sogar örtlich lokalisierbar ist.

Die beschriebene Überwachung gestaltet sich erheblich einfacher als bisher, wo eine Überprüfung des piezoelektrischen Elements nur durch ein Vermessen desselben in einer Prüfvorrichtung erfolgen konnte; das piezoelektrische Element kann im eingebauten Zustand während des normalen Betriebes überwacht bzw. getestet werden, und die Überwachung bzw. der Test kann im wesentlichen ohne komplizierte Zusatzeinrichtungen, insbesondere auch ohne Strommesser oder dergleichen durchgeführt werden.

Anordnungen, die wie vorstehend beschrieben ansteuerbar sind, können besonders einfach aufgebaut werden, da zum Laden und zum Entladen des piezoelektrischen Elements mangels strenger Anforderungen an die technischen Daten ein und die selbe Spule (bei der Anordnung gemäß Figur 1 die Spule 2) verwendbar ist. Dadurch kann die Anzahl der Bauelemente, insbesondere die Anzahl der von Haus aus relativ großen Spulen minimal gehalten werden. Anstelle der Spule(n) können bei entsprechend modifiziertem Schaltungsaufbau übrigens auch andere induktive Eigenschaften aufweisende Bauelemente wie beispielsweise Übertrager, Transformatoren etc. verwendet werden.

Anstelle des einen piezoelektrischen Elements 1 können auf die vorstehend beschriebene Art und Weise auch einzelne oder mehrere piezoelektrische Elemente einer Vielzahl von parallel angeordneten und über Auswahlschalter selektierbaren piezoelektrischen Elementen geladen oder entladen werden.

Zusammenfassend kann abschließend festgestellt werden, daß sich durch die wie beschrieben erfolgende Betätigung des Ladeschalters und des Entladeschalters, genauer gesagt durch das dadurch bewerkstelligte Laden und Entladen des piezoelektrischen Elements durch einen vorgebbaren mittleren Lade- bzw. Entladestrom auf eine vorgegebene Spannung ein für das piezoelektrische Element schonendes und einfach an die individuellen oder wechselnde Verhältnisse anpaßbares Laden und Entladen durchführen läßt.

## Patentansprüche

1. Verfahren zum Laden und Entladen eines piezoelektrischen Elements (1), wobei der das piezoelektrische Element ladende Ladestrom bzw. der das piezoelektrische Element entladende Entladestrom über ein induktive Eigenschaften aufweisendes Bauelement (2) geführt wird, wobei ein im Ladestromkreis vorgesehener Schalter (3) bzw. ein im Entladestromkreis vorgesehener Schalter (5) während des Ladens bzw. Entladens derart wiederholt betätigt wird, dass das piezoelektrische Element durch einen vorgegebenen mittleren Lade bzw. Entladestrom auf eine vorgegebene Spannung gebracht wird, dass das Laden bzw. Entladen beendet wird, wenn eine Messung der sich am piezoelektrischen Element einstellenden Spannung ergibt, dass diese eine Sollspannung erreicht hat.

2. Verfahren nach Anspruch 1, **dadurch gekennzeichnet, dass** das piezoelektrische Element (1) als Aktor in einer Kraftstoffeinspritzdüse einer Brennkraftmaschine verwendet wird.

3. Verfahren nach Anspruch 2, **dadurch gekennzeichnet, dass** der mittlere Lade- bzw. Entladestrom und die vorgegebene Spannung variabel sind und insbesondere in Abhängigkeit von wenigstens der pro Einspritzvorgang einzuspritzenden Kraftstoffinenge, der Motordrehzahl, dem Druck im Rail oder der Motortemperatur festgelegt werden.

4. Verfahren nach einem der vorhergehenden Ansprüche, **dadurch gekennzeichnet, dass** die Zeitpunkte, zu denen der zu betätigende Schalter (3, 5) geöffnet und geschlossen werden muss, in einer Speichereinrichtung gespeichert sind und während des Betriebs des piezoelektrischen Elements (1) aus dieser ausgelesen werden.

5. Verfahren nach einem der Ansprüche 1 bis 3, **dadurch gekennzeichnet, dass** die Zeitpunkte, zu denen der zu betätigende Schalter (3, 5) geöffnet und geschlossen werden muss, während des Betriebs des piezoelektrischen Elements (1) aktuell berechnet werden.

6. Verfahren nach Anspruch 4 oder 5, **dadurch gekennzeichnet, dass** das Auslesen der Zeitpunkte, zu denen der zu betätigende Schalter (3, 5) geöffnet und geschlossen werden muss bzw. die Berechnung derselben unter Berücksichtigung des Betriebszustandes erfolgt, in welchem sich die das zu ladende bzw. zu entladende piezoelektrische Element (1) enthaltende Einrichtung zum betreffenden Zeitpunkt befindet.

7. Verfahren nach einem der Ansprüche 1 bis 3, **dadurch gekennzeichnet, dass** der Ladestrom bzw. der Entladestrom fortlaufend gemessen und durch ein entsprechendes Öffnen und Schließen des zu betätigenden Schalters (3, 5) so nachgeregelt wird, dass er innerhalb eines definierten Bandes um einen Soll-Strom bleibt.

8. Verfahren nach Anspruch 7, **dadurch gekennzeichnet, dass** die Zeit gemessen wird, die von einem bestimmten Ereignis oder Zeitpunkt an vergeht, bis der Ladestrom bzw. der Entladestrom die obere oder die untere Grenze des um den Soll-Strom definierten Bandes erreicht hat oder bis die sich am piezoelektrischen Element einstellende Spannung die Soll-Spannung erreicht hat.

9. Vorrichtung zum Laden und Entladen eines piezoelektrischen Elements (1), wobei der das piezoelektrische Element ladende Ladestrom bzw. der das piezoelektrische Element entladende Entladestrom über ein induktive Eigenschaften aufweisendes Bauelement (2) geführt wird, wobei eine Regeleinrichtung dazu ausgelegt ist, einen im Ladestromkreis vorgesehener Schalter (3) bzw. ein im Entladestromkreis vorgesehener Schalter (5) während des Ladens bzw. Entladens derart wiederholt zu betätigen, dass das piezoelektrische Element durch einen vorgegebenen mittleren Lade bzw. Entladestrom auf eine vorgegebene Spannung gebracht wird, und dass das Laden bzw. Entladen beendet wird, wenn eine Messung der sich am piezoelektrischen Element einstellenden Spannung ergibt, dass diese eine Sollspannung erreicht hat.

## Claims

1. Method for charging and discharging a piezoelectric element (1), with the charging current which charges the piezoelectric element and the discharge current which discharges the piezoelectric element being passed via a component (2) which has inductive characteristics, with a switch (3) which is provided in the charging circuit or a switch (5) which is provided in the discharge circuit being operated repeatedly during charging or discharging, respectively, such that the piezoelectric element is raised to a predetermined voltage by a predetermined mean charging current or discharge current, such that the charging or discharging is ended when a measurement of the voltage that is produced across the piezoelectric element indicates that this voltage has reached a set voltage.

2. Method according to Claim 1, **characterized in that** the piezoelectric element (1) is used as an actuator in a fuel injection nozzle for an internal combustion engine.

3. Method according to Claim 2, **characterized in that** the mean charging current or discharge current and the predetermined voltage are variable and, in particular, are defined as a function of at least the amount of fuel to be injected per injection process, of the engine rotation speed, of the pressure in the rail, or of the engine temperature.

4. Method according to one of the preceding claims, **characterized in that** the times at which the switch (3, 5) to be operated must be opened and closed are stored in a memory device and are read from this memory device during operation of the piezoelectric element (1).

5. Method according to one of Claims 1 to 3, **characterized in that** the times at which the switch (3, 5) to be operated must be opened and closed are calculated at the time during operation of the piezoelectric element (1).

6. Method according to Claim 4 or 5, **characterized in that** the reading of the times at which the switch (3, 5) to be operated must be opened and closed, or their calculation, is carried out taking account of the operating state which the device which contains the piezoelectric element (1) that is to be charged or is to be discharged is in at the relevant time.

7. Method according to one of Claims 1 to 3, **characterized in that** the charging current or the discharge current is measured continuously and is readjusted by appropriate opening and closing of the switch (3, 5) to be operated, such that it remains within a defined band around a set current.

8. Method according to Claim 7, **characterized in that** the time is measured which passes from a specific event or time until the charging current or the discharge current has reached the upper or the lower limit of the band which is defined around the set current, or until the voltage which is produced across the piezoelectric element has reached the set voltage.

9. Apparatus for charging and discharging a piezoelectric element (1), with the charging current which charges the piezoelectric element or the discharge current which discharges the piezoelectric element being passed via a component (2) which has inductive characteristics, with a control device being designed to operate a switch (3), which is provided in the charging circuit, or a switch (5), which is provided in the discharge circuit, repeatedly during charging or discharging, respectively, such that the piezoelectric element is raised by means of a predetermined mean charging current or discharge current to a predetermined voltage, and such that the charging or discharging is ended when a measurement of the voltage which is produced across the piezoelectric element indicates that this voltage has reached a set voltage.

## Revendications

1. Procédé pour charger et décharger un élément piézo-électrique (1) dans lequel
le courant de charge chargeant l'élément piézo-électrique, ou le courant de décharge déchargeant l'élément piézo-électrique, est conduit à travers un module (2) possédant des propriétés inductives, dans lequel un commutateur (3) prévu dans le circuit de courant de charge, ou un commutateur (5) prévu dans le circuit de courant de décharge, est actionné de manière répétitive pendant la charge ou la décharge, de telle manière que l'élément piézo-électrique est porté à une tension prédéfinie par un courant moyen prédéfini de charge ou de décharge, que la charge, ou la décharge, est terminée lorsqu'une mesure de la tension s'établissant au niveau de l'élément piézo-électrique détermine que celle-ci a atteint une tension de consigne.

2. Procédé selon la revendication 1,
**caractérisé en ce que**
l'élément piézo-électrique (1) est utilisé en tant qu'actionneur dans une buse d'injection de carburant d'un moteur à combustion interne.

3. Procédé selon la revendication (2),
**caractérisé en ce que**
le courant moyen de charge ou de décharge et la tension prédéfinie sont variables et sont, en particulier, définis en fonction d'au moins la quantité de carburant à injecter par processus d'injection, du régime du moteur, de la température dans la rampe ou de la température du moteur.

4. Procédé selon l'une quelconque des revendications précédentes,
**caractérisé en ce que**
les moments auxquels le commutateur à actionner (3, 5) doit être ouvert et fermé sont stockés dans un dispositif de stockage et lus à partir de celui-ci pendant le fonctionnement de l'élément piézo-électrique (1).

5. Procédé selon l'une quelconque des revendications 1 à 3,
**caractérisé en ce que**
les moments auxquels le commutateur à actionner (3, 5) doit être ouvert et fermé doivent être mis à jour par calcul pendant le fonctionnement de l'élément piézo-électrique (1).

6. Procédé selon la revendication 4 ou 5,
**caractérisé en ce que**
la lecture des moments auxquels le commutateur à actionner (3, 5) doit être ouvert et fermé, ou le calcul de ceux-ci, s'effectue en tenant compte de l'état de fonctionnement dans lequel se trouve au moment concerné le dispositif contenant l'élément piézo-électrique (1) à charger ou à décharger.

7. Procédé selon l'une quelconque des revendications 1 à 3,
**caractérisé en ce que**
le courant de charge ou le courant de décharge est mesuré en permanence et postrégulé par une ouverture ou une fermeture en accord du commutateur (3, 5) à actionner de telle manière qu'il demeure à l'intérieur d'une plage définie autour d'un courant de consigne.

8. Procédé selon la revendication 7,
**caractérisé en ce que**
la durée s'écoulant depuis un certain événement ou moment est mesurée jusqu'à ce que le courant de charge ou le courant de décharge ait atteint la limite supérieure ou inférieure de la plage définie autour du courant de consigne ou jusqu'à ce que la tension s'établissant au niveau de l'élément piézo-électrique ait atteint la tension de consigne.

9. Dispositif pour charger et décharger un élément piézo-électrique (1), dans lequel
le courant de charge chargeant l'élément piézo-électrique ou le courant de décharge déchargeant l'élément piézo-électrique est conduit à travers un module (2) possédant des propriétés inductives, dans lequel un dispositif de régulation est constitué de telle manière qu'un commutateur (3) prévu dans le circuit de courant de charge, ou un commutateur (5) prévu dans le circuit de courant de décharge, est actionné de manière répétitive pendant la charge ou la décharge, de telle manière que l'élément piézo-électrique est porté à une tension prédéfinie par un courant moyen prédéfini de charge ou décharge et que la charge, ou la décharge, est terminée lorsqu'une mesure de la tension s'établissant au niveau de l'élément piézo-électrique détermine que celle-ci a atteint une tension de consigne.
